# EUROPEAN PATENT SPECIFICATION

(11) **EP 4 580 319 B1**
(45) Date of publication and mention of the grant of the patent: **28.10.2026**
(21) Application number: 23867330.5
(22) Date of filing: 11.09.2023
(51) Int. Cl.: H04M 1/02, H01Q 1/24, H05K 1/181

(54) **ELECTRONIC DEVICE**
ELEKTRONISCHE VORRICHTUNG
DISPOSITIF ÉLECTRONIQUE

(30) Priority: 24.09.2022 CN 202211168624
(43) Date of publication of application: 02.07.2025
(73) Proprietor: Huawei Technologies Co., Ltd., Shenzhen, Guangdong 518129 (CN)
(72) Inventor: SHI, Hongbin, Shenzhen, Guangdong 518129 (CN); LIU, Xiaoyang, Shenzhen, Guangdong 518129 (CN)
(74) Representative: Gill Jennings & Every LLP
(86) International application number: PCT/CN2023/117988
(87) International publication number: WO 2024/061041

(56) References cited:
- CN-A- 112 739 078
- CN-A- 113 540 786
- CN-A- 114 585 150
- CN-A- 115 589 664
- CN-U- 212 115 762
- CN-U- 216 491 275
- US-A1- 2022 174 137

## Description

### TECHNICAL FIELD

This application relates to the field of communication devices, and in particular, to an electronic device.

### BACKGROUND

An existing electronic device usually includes a mainboard, and the mainboard includes a circuit board and a plurality of electronic components mounted on the circuit board. As a main part of a mainboard of a mobile phone, a circuit board functions to electrically connect and support electronic components. However, the circuit board has a large board surface, and is prone to deformation or cracking, resulting in degradation or failure of electrical connection performance of the circuit board.

US2022174137A1 discloses An electronic device that includes a housing including a first plate, a second plate, and a side member, a support member disposed in the space between the first plate and the second plate, a first conductive area included in the side member, a protruding area included in the first conductive area protruding from the first conductive area toward an interior of the housing, and electrically connected to the first conductive area, a first circuit board disposed on one surface of the support member, a reinforcement member protruding from the one surface of the support member toward the second direction, a second circuit board extending further than the first circuit board toward the protruding area, and disposed on the reinforcement member, and a connection member electrically connecting the protruding area and the second circuit board, and disposed on the second circuit board.

### SUMMARY

The invention is set out in the independent claim 1, further embodiments being set out in the dependent claims.

An objective of this application is to provide an electronic device. According to the electronic device provided in this application, a reinforcement member is disposed on a periphery that is of a circuit board and that is close to a frame, so that mechanical strength of the circuit board can be improved, and reliability of the circuit board can be improved. In addition, the reinforcement member is transmissive for radio frequency signals, and does not affect electrical performance of a radio frequency component disposed on a periphery of the circuit board, so that an antenna has good radiation performance, and the electronic device has good communication performance.

This application provides an electronic device. The electronic device provided in this application includes a frame, a circuit board, and a radio frequency component. The frame includes a metal member, and the metal member is used as an antenna. The circuit board is mounted on an inner side of the frame, the circuit board includes a board body and a reinforcement member, the board body has a peripheral region close to the frame, the reinforcement member is disposed in the peripheral region of the board body, and the reinforcement member is transmissive for radio frequency signals.

The radio frequency component is electrically connected to the circuit board, the radio frequency component is located in the peripheral region of the board body and is electrically connected to the metal member of the frame, and the radio frequency component is configured to transmit an electrical signal to the antenna or receive an electrical signal from the antenna. A projection of the radio frequency component on a plane on which the board body is located is a first projection, a projection of the reinforcement member on the plane on which the board body is located is a second projection, and at least a part of the first projection is located in a range of a projection region of the second projection.

In this application, the reinforcement member is disposed in the peripheral region of the board body, so that mechanical strength of the peripheral region of the board body can be improved, and reliability of the circuit board can be improved. In addition, the radio frequency component is located in the peripheral region of the board body, so that the radio frequency component is disposed close to the frame, and a transmission distance between the radio frequency component and the antenna located on the frame is short, to reduce a transmission loss and improve antenna performance. Further, at least a part of the first projection is located in the range of the projection region of the second projection, so that the radio frequency component is disposed near the reinforcement plate. The reinforcement member is transmissive for radio frequency signals, and does not affect a radio frequency signal of the radio frequency component disposed near the reinforcement plate, to ensure electrical performance of the radio frequency component, so that the antenna has good radiation performance, and the electronic device has good communication performance.

In some implementations, the electronic device includes a camera module, the board body is provided with an opening, the camera module is located at the opening, the reinforcement member is disposed on a periphery of the opening, and the radio frequency component is disposed between the camera module and the frame.

In the implementations, the opening of the board body is configured to avoid a component such as the camera module, so that a structure in an internal cavity of the entire electronic device is compact, to meet a requirement of a structure design of the electronic device. The reinforcement structure is disposed on the periphery of the opening, so that mechanical strength of a part of the board body on the periphery of the opening can be improved, and reliability of the circuit board can be improved. In addition, the radio frequency component is disposed between the camera module and the frame, so that a radio frequency signal sent by the radio frequency component is not blocked by the camera module. In this way, the radio frequency component has excellent radiation performance.

In some implementations, the opening extends to an edge of the board body.

In the implementations, the opening may extend to the edge of the board body. In this case, an opening exists at an edge of a part of the board body on a periphery of the opening. Consequently, the part of the board body on the periphery of the opening has lower strength, and is more likely to be affected by stress and deformed. Therefore, it is more necessary to dispose a reinforcement structure.

In some implementations, the radio frequency component is located on a side that is of the reinforcement member and that is away from the board body, or the radio frequency component and the reinforcement member are located on two sides of the board body and face away from each other.

In the implementations, a location of the reinforcement member is flexible, and different locations may be selected according to an internal structure design of the electronic device, to meet a space requirement.

In some implementations, the reinforcement member is made of a nonmetal material.

In the implementations, the nonmetal material has small impact on a radio frequency signal, so that the reinforcement member is is transmissive for radio frequency signals.

In some implementations, a dielectric constant of the reinforcement member is less than or equal to 5, and a dielectric loss of the reinforcement member is less than or equal to 0.17.

In the implementations, the dielectric constant and the dielectric loss of the reinforcement member are limited, so that the reinforcement member is transmissive for radio frequency signals.

In some implementations, the reinforcement member is formed by curing an adhesive applied to a surface of the board body.

In the implementations, the reinforcement member is formed by curing the adhesive applied to the surface of the board body, so that the reinforcement member is securely connected to the board body.

In some implementations, the reinforcement member is made of polyester, epoxy resin, or polyimide.

In the implementations, the polyester is easy to form a film, and connection to the board body is more secure. The reinforcement member may alternatively be made of epoxy resin, polyimide, or the like.

In some implementations, the reinforcement member includes a main body and a plurality of filling members, an elastic modulus of the filling member is greater than an elastic modulus of the main body, the main body is fastened to the board body, and the plurality of filling members are distributed on the main body.

In the implementations, the filling member can improve mechanical strength of the reinforcement member, to improve mechanical strength of the peripheral region of the board body.

In some implementations, the circuit board includes an adhesive member disposed between the board body and the reinforcement member, and the reinforcement member is fastened to the board body by using the adhesive member.

In the implementations, the adhesive member may be pre-made on the board body or the reinforcement member, to simplify a process step of fastening the reinforcement member to the board body.

In some implementations, the adhesive member is glue or a double-sided tape.

In the implementations, the adhesive member may be a glue film formed by glue on a single side surface of the reinforcement member. The glue film may be bonded to the surface of the board body in a manner of thermal curing, moisture curing, UV curing, or the like, so that the reinforcement member is fastened to the board body. The adhesive member may alternatively be formed by curing glue. Glue may be applied to a single side surface of the reinforcement member, and the side to which the glue is applied is bonded to the board body, so that the reinforcement member is fastened to the board body. In addition, two sides of the double-sided tape are sticky, and are bonded to the reinforcement member and the board body respectively, and a process is simple.

In some implementations, the adhesive member is made of acrylic resin or modified epoxy resin.

In the implementations, the adhesive member is transmissive for radio frequency signals, and does not affect a radio frequency signal passing through the radio frequency component, to ensure electrical performance of the radio frequency component.

### BRIEF DESCRIPTION OF DRAWINGS

FIG. 1 is a diagram of a structure of an electronic device in some embodiments according to this application;
FIG. 2 is a diagram of a partial structure of the electronic device shown in FIG. 1;
FIG. 3 is a partial diagram of the structure shown in FIG. 2;
FIG. 4 is a diagram of a partial structure of the electronic device shown in FIG. 3 in some other embodiments;
FIG. 5 is a diagram of an internal partial structure of the electronic device shown in FIG. 3;
FIG. 6 is a diagram of projections of a reinforcement member and a radio frequency component shown in FIG. 3 on a plane on which a board body is located;
FIG. 7 is a diagram of a partial structure of the electronic device shown in FIG. 3 in still some other embodiments; and
FIG. 8 is a diagram of a partial structure of the electronic device shown in FIG. 3 in yet some other embodiments.

### DESCRIPTION OF EMBODIMENTS

The following describes embodiments of this application with reference to accompanying drawings in embodiments of this application. In descriptions of embodiments of this application, "a plurality of" means two or more than two, unless otherwise specified. In addition, "connection" in this specification should be understood in a broad sense. For example, "connection" may be detachable connection, non-detachable connection, direct connection, or indirect connection through an intermediate medium. In addition, "fastening" in this specification should also be understood in a broad sense. For example, "fastening" may be direct fastening or indirect fastening through an intermediate medium.

The term "and/or" in this specification describes only an association relationship between associated objects and indicates that there may be three relationships. For example, A and/or B may indicate the following three cases: Only A exists, both A and B exist, and only B exists. In addition, in the descriptions of embodiments of this application, "a plurality of" means two or more than two, unless otherwise specified.

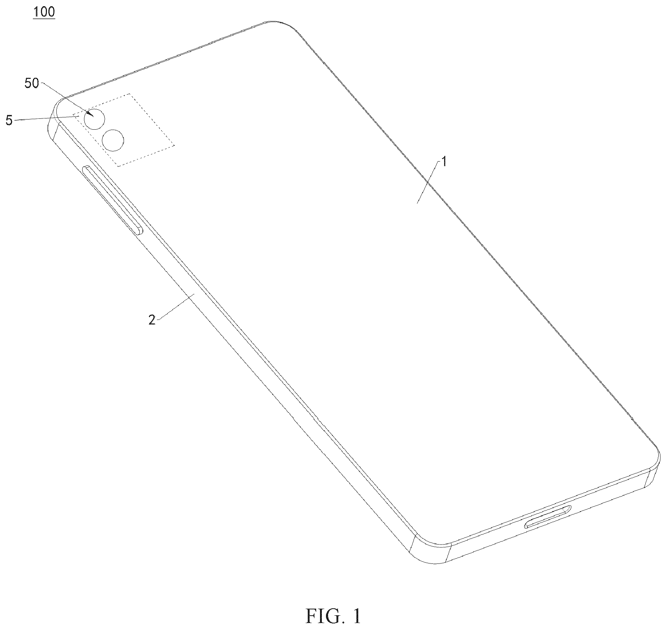

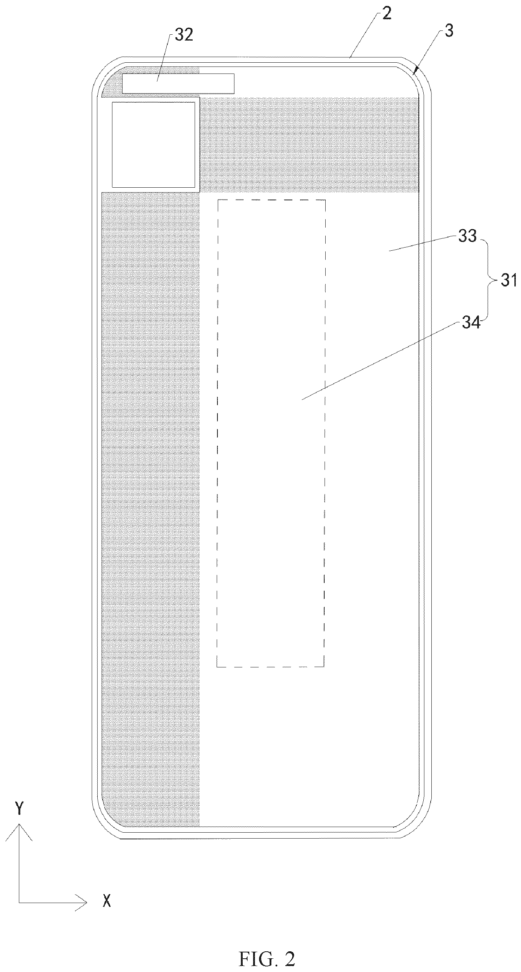

Refer to FIG. 1 and FIG. 2. FIG. 1 is a diagram of a structure of an electronic device 100 in some embodiments according to this application. FIG. 2 is a diagram of a partial structure of the electronic device 100 shown in FIG. 1. For example, the electronic device 100 provided in this application may be an electronic product such as a mobile phone, a tablet computer, a notebook computer, a wearable device, a point of sales terminal (point of sales terminal, POS terminal for short), or a router. In embodiments of this application, an example in which the electronic device 100 is a mobile phone is used for description. The mobile phone may be a bar-type phone or a foldable phone.

For example, the electronic device 100 may include a rear cover 1, a frame 2, a display (not shown in FIG. 1), a circuit board 3, and a camera module 5. The display is configured to display an image, and the display may further integrate a touch function to implement human-machine interaction. The rear cover 1 is configured to protect an internal structure of the electronic device 100. The rear cover 1 may be made of a metal material, or may be made of a nonmetal material, or may be made of a composite material of metal and nonmetal.

In some embodiments, the rear cover 1 and the display are fastened to two sides of the frame 2 and face away from each other, and the rear cover 1, the frame 2, and the display jointly enclose an internal cavity of the entire electronic device 100. The circuit board 3 and the camera module 5 are located in the internal cavity of the entire electronic device 100. The camera module 5 is configured to collect optical information outside the electronic device 100, and form corresponding image data.

For example, the rear cover 1 is provided with a camera hole 50, the camera module 5 collects optical information outside the electronic device through the camera hole 50, and the camera module 5 is a rear-facing camera module of the electronic device 100. In some other embodiments, the display is provided with a light transmission region, the camera module 5 collects optical information outside the electronic device 100 through the light transmission region, and the camera module 5 is a front-facing camera module of the electronic device 100. In other words, the camera module 5 may be a front-facing camera module of the electronic device 100, or may be a rear-facing camera module of the electronic device 100. This is not strictly limited in embodiments of this application.

For example, there may be a plurality of camera holes 50. The plurality of camera holes 50 may be spaced and arranged along a straight line, or may be arranged in an array. The plurality of camera holes 50 may be arranged in a pattern such as a circle, a triangle, or a polygon.

For example, the rear cover 1 and the frame 2 may be of an integrated structure. Two components being of an integrated structure means that, during formation of one of the two components, the component is connected to the other component, with no need to connect the two components through further processing (for example, bonding, welding, fastener connection, or screw connection).

In some embodiments, the electronic device 100 may further include a processor, an antenna, a communication module, an audio module, a speaker, a receiver, a microphone, a sensor module, and the like.

The processor may be configured to process instructions and/or data. The processor may include one or more processing units. For example, the processor may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors.

The electronic device 100 may implement a photographing function by using the camera module 5 and the processor. The camera module 5 is configured to capture an image or a video. An optical image of an object is generated through a lens, and is projected on a photosensitive element. The photosensitive element is configured to convert an optical signal into a radio frequency signal. The photosensitive element may be a charge-coupled device (charge-coupled device, CCD) or a complementary metal-oxide-semiconductor (complementary metal-oxide-semiconductor, CMOS) phototransistor. In some embodiments, the camera module 5 may include one or more cameras. The processor is configured to control the camera module 5 to perform photographing or video recording, and is further configured to convert a radio frequency signal output by the camera module 5 into an image signal. The camera module 5 may implement an automatic focusing function, an optical image stabilization function, and the like.

A wireless communication function of the electronic device 100 may be implemented by using the antenna, the communication module, the processor, and the like. The antenna is configured to transmit and receive radio frequency signals. There are a plurality of antennas. The plurality of antennas may work independently of each other, or may work in combination. Each antenna in the electronic device 100 may be configured to cover one or more communication frequency bands. Different antennas may be reused, to improve antenna utilization.

The antenna of the electronic device 100 is coupled to the communication module, so that the electronic device 100 can communicate with a network and another device by using a wireless communication technology. The communication module may be one or more components integrating at least one communication processing module. The communication module receives a radio frequency signal through the antenna, performs frequency modulation and filtering on the radio frequency signal, and sends a processed signal to the processor. The wireless communication module may further receive a to-be-sent signal from the processor, perform frequency modulation and amplification on the signal, and convert the signal into a radio frequency signal through the antenna for radiation. In some embodiments, at least a part of functional modules of the communication module may be disposed in the processor. In some embodiments, at least a part of functional modules of the communication module and at least a part of modules of the processor may be disposed in a same component.

The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), Bluetooth (Bluetooth, BT), a global positioning system (global positioning system, GPS), a global navigation satellite system (global navigation satellite system, GNSS), a wireless local area network (wireless local area network, WLAN) (such as a wireless fidelity (wireless fidelity, Wi-Fi) network), a near field communication (near field communication, NFC) technology, frequency modulation (frequency modulation, FM), an infrared (infrared, IR) technology, and/or the like.

For example, the communication module may include a baseband module and a plurality of radio frequency components. The baseband module may include but is not limited to a radio frequency chip, a baseband chip, and a related peripheral circuit. The plurality of radio frequency components are connected between the baseband module and the antenna, and are configured to transmit and process radio frequency signals. The plurality of radio frequency components can form a transmit channel and a receive channel, and a radio frequency signal is transmitted through the transmit channel and the receive channel. A frequency of the radio frequency signal ranges from 300 kHz to 300 GHz. A radio frequency signal with a high frequency is likely to be affected by a metal environment, and consequently electrical performance of the radio frequency component is affected by the metal environment. For example, if a metal structure is disposed in the radio frequency component, the metal structure may damage electrical performance of the radio frequency component.

The transmit channel can perform processing such as amplification and filtering on a radio frequency signal from the baseband module, and then transmit the radio frequency signal to the antenna, and the antenna transmits the radio frequency signal. The receive channel can perform processing such as filtering and amplification on a radio frequency signal received by the antenna, and then transmit the radio frequency signal to the baseband module for subsequent processing.

In some embodiments, the plurality of radio frequency components may include one or more of the following: a low noise amplifier (low noise amplifier, LNA), a power amplifier (power amplifier, PA), a filter, and a radio frequency switch. In some other embodiments, the plurality of radio frequency components may further include another radio frequency component that is not listed above. This is not limited in this application.

The power amplifier (power amplifier, PA) and the low noise amplifier (low noise amplifier, LNA) are configured to increase power of a signal under a given distortion rate. The filter is configured to filter out clutter of a signal, to obtain a required signal. The radio frequency switch is connected between the antenna and both the receive channel and the transmit channel, and is used for time-division connection between the antenna and both the receive channel and the transmit channel.

The electronic device 100 may implement an audio function, for example, music playing, recording, and receiving and playing of audio information during a call, by using the audio module, the speaker, the receiver, the microphone, the processor, and the like.

The audio module is configured to convert digital audio information into an analog audio signal output, and is further configured to convert an analog audio input into a digital audio signal. The audio module may be further configured to encode and decode audio signals. **In** some embodiments, the audio module may be disposed in the processor, or a part of functional modules of the audio module is disposed in the processor.

The speaker, also referred to as a "loudspeaker", is configured to convert an audio radio frequency signal into a sound signal. The electronic device 100 may be used to listen to music or answer a hands-free call over the speaker.

The receiver, also referred to as an "earpiece", is configured to convert an audio radio frequency signal into a sound signal. When the electronic device 100 is used to answer a call or receive voice information, the receiver may be put close to a human ear to listen to a voice.

The microphone, also referred to as a "mike" or a "mic", is configured to convert a sound signal into a radio frequency signal. When making a call or sending voice information, a user may place the mouth of the user near the microphone to make a sound, to input a sound signal to the microphone. At least one microphone may be disposed in the electronic device 100. **In** some other embodiments, two microphones may be disposed in the electronic device 100, to collect a sound signal and implement a noise reduction function. **In** some other embodiments, three, four, or more microphones may alternatively be disposed in the electronic device 100, to collect a sound signal, implement noise reduction, recognize a sound source, implement a directional recording function, and the like.

The electronic device 100 may have more or fewer components than those described above, may combine two or more components, or may have a different component configuration. Various components may be implemented by using hardware including one or more signal processors and/or application-specific integrated circuits, software, or a combination of hardware and software.

The circuit board 3 has a function of electrically connecting and supporting electronic components. A plurality of components may be electrically connected by using the circuit board 3. A required circuit can be obtained by selectively performing processing processes such as hole machining, copper plating, and etching on the circuit board 3, to implement electrical connection between the plurality of components. A part of the plurality of components may be mounted on the circuit board 3 in a fixed manner.

For example, the circuit board 3 may be a PCB (printed circuit board, printed circuit board), or may be an FPC (flexible printed circuit, flexible printed circuit). The PCB may be a copper clad laminate (copper clad laminate, CCL) board. A reinforcing material of the copper clad laminate board may be paper, glass fiber, ceramic, silicon dioxide, boron nitride, metal, resin, a composite material, or the like. This is not strictly limited in embodiments of this application. The FPC may be electrically connected to the PCB by using a structure such as a BTB (board-to-board, board-to-board) connector or a gold finger.

Refer to FIG. 2. In some embodiments, the circuit board 3 is mounted on an inner side of the frame 2. An edge of the circuit board 3 is close to the frame 2. In other words, a distance between the edge of the circuit board 3 and the frame 2 is small. The circuit board 3 includes a board body 31 and a reinforcement member 32. The board body 31 has a peripheral region 33 close to the frame 2 and a middle region 34 away from the frame 2. An area occupied by the board body 31 is divided into the peripheral region 33 and the middle region 34 by using a dashed line box in FIG. 2. It should be noted that FIG. 2 shows merely one division manner of the peripheral region 33 and the middle region 34. The area occupied by the board body 31 may alternatively be divided in another manner. For example, the peripheral region 33 may alternatively be in another shape, or may occupy a larger or smaller area. This is not limited in this application.

For example, the peripheral region 33 may be disposed around the middle region 34.

The reinforcement member 32 is disposed in the peripheral region 33 of the board body 31. In embodiments of this application, the board body 31 of the circuit board 3 may be a board structure that occupies a large part of a region of the internal cavity of the entire electronic device 100. In this case, the board body 31 has a large board surface, and the peripheral region 33 of the board body 31 is prone to deformation or cracking under stress, resulting in degradation or failure of electrical connection performance of a part of the circuit board 3. The reinforcement member 32 is disposed in the peripheral region 33 of the board body 31, so that mechanical strength of the peripheral region 33 of the board body 31 can be improved, and reliability of the circuit board 3 can be improved.

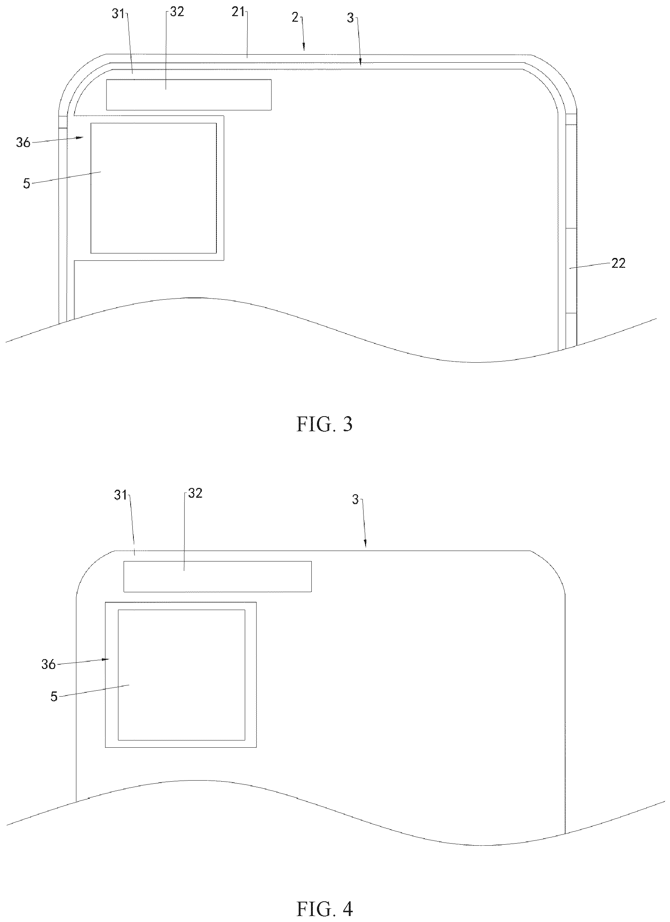

FIG. 3 is a partial diagram of the structure shown in FIG. 2.

For example, the frame 2 may include a metal member 21 and an insulating member 22. The metal member 21 is adjacent to the insulating member 22.

The metal member 21 may form an antenna of the electronic device 100. For example, there may be one antenna, and one antenna may cover one or more communication frequency bands. There may alternatively be a plurality of antennas, and different antennas may cover different communication frequency bands. A plurality of metal members 21 may form one antenna, or one metal member 21 may form one antenna. Different metal members 21 may form different antennas, or one metal member 21 may be reused as a plurality of antennas.

For example, the antenna may be located at the top and/or the bottom of the electronic device 100. When using the electronic device 100, the user usually holds the middle of the frame 2. The antenna is disposed at the top and/or the bottom of the electronic device 100, so that the antenna can be prevented from being blocked by an obstacle during signal sending and receiving, to improve signal transmission efficiency.

It may be understood that a length, a material, a shape, a surrounding structure, and the like of the metal member 21 determine an operating frequency band of the antenna. A parameter of the metal member 21 may be designed according to a requirement. This is not limited in this application.

For example, the metal member 21 may be made of a metal material, for example, aluminum, copper, or silver. The insulating member 22 may be made of an insulating material, for example, glass or resin. In some other embodiments, the metal member 21 of the frame 2 may alternatively be disposed as a nonmetal section made of a conductive nonmetal material, for example, conductive rubber or graphite. In this case, the nonmetal section may also be used as an antenna.

For example, a metal structure such as a dipole antenna, a monopole antenna, an inverted F-shaped antenna (inverted F-shaped antenna, IFA), or a patch antenna may be further disposed on the frame, and the metal structure may be fastened on an inner side of the insulating member 22.

In this application, the insulating member 22 may be made of a nonmetal material, and is transmissive for radio frequency signals. In other words, a radio frequency signal loses almost no energy when passing through the insulating member 22. In the embodiments, an antenna is disposed on an inner side of the insulating member 22, and the antenna sends a radio frequency signal that is transmitted to the outside of the electronic device 100 through the insulating member 22, or receives a radio frequency signal that is transmitted from the outside of the electronic device 100 to the inside of the electronic device 100 through the insulating member 22. Because the insulating member 22 is transmissive for radio frequency signals, the radio frequency signal loses almost no energy when passing through the insulating member 22, so that radiation performance of the antenna is improved.

For example, there are a plurality of metal members 21, and there may also be a plurality of insulating members 22.

For example, the frame 2 may further include a mechanical part configured to form appearance of the electronic device 100. The mechanical part may be made of a metal material, or may be made of a nonmetal material. This is not limited in this application. The mechanical part is located in the middle of the electronic device 100.

For example, the board body 31 of the circuit board 3 may be provided with an opening 36. The camera module 5 of the electronic device 100 may be located at the opening. The opening of the board body 31 is configured to avoid a component such as the camera module 5, so that a structure in the internal cavity of the entire electronic device 100 is compact, to meet a requirement of a structure design of the electronic device 100.

The camera module 5 is generally disposed at the top of the electronic device 100. During photographing, the user is accustomed to holding a lower end of the electronic device 100. The camera module 5 is disposed at the top of the electronic device 100. This conforms to a photographing habit of the user, to prevent the camera from being blocked due to holding by the user, and good photographing effect can be achieved. Therefore, the opening 36 is also disposed at the top of the electronic device 100, to avoid the camera module 5.

The reinforcement member 32 is disposed on a periphery of the opening 36. A part of the board body 31 on a periphery of the opening 36 is prone to deformation or cracking under stress, resulting in degradation or failure of electrical connection performance of the part of the board body 31. The reinforcement structure is disposed on the periphery of the opening 36, so that mechanical strength of the part of the board body 31 on the periphery of the opening 36 can be improved, and reliability of the circuit board 3 can be improved.

For example, the reinforcement member 32 may be disposed around the opening 36, that is, occupy an entire region of the periphery of the opening 36; or may be located in a part of the region of the periphery of the opening 36.

For example, a radio frequency component 4 is disposed between the camera module 5 and the frame 2, so that a radio frequency signal sent by the radio frequency component 4 is not blocked by the camera module 5. In this way, the radio frequency component 4 has excellent radiation performance.

For example, as shown in FIG. 2, at least a part of the reinforcement member 32 is located in a range of the opening 36 in a first direction X and/or a second direction Y, and extends to an outer side of the range of the opening 36 in the first direction X and/or the second direction Y. In embodiments of this application, the first direction X is parallel to one side of the board body 31, and the second direction Y is parallel to a plane on which the board body 31 is located and is perpendicular to the first direction X. The range of the opening 36 in the first direction X is a region swept along the second direction Y by a connection line between two farthest points of the opening in the first direction X (for example, a shaded region shown in FIG. 2). The range of the opening 36 in the second direction Y is a region swept along the first direction X by a connection line between two farthest points of the opening in the second direction Y (for example, a shaded region shown in FIG. 2).

In the embodiments, the reinforcement member 32 extends to the outer side of the range of the opening 36 in the first direction X and/or the second direction Y, so that the reinforcement member 32 can connect a part of the board body 31 located in the range of the opening 36 in the first direction X and/or the second direction Y to a part of the board body 31 located outside the range of the opening 36 in the first direction X and/or the second direction Y. This further improves the mechanical strength of the part of the board body 31 on the periphery of the opening 36, and improves reinforcement effect of the reinforcement member 32.

FIG. 2 shows merely an arrangement manner of the camera module 5 of the electronic device 100 in an embodiment, and shall not be considered as a limitation on an internal structure of the electronic device 100. The camera module 5 of the electronic device 100 may alternatively be located in another location, and the electronic device 100 may further have another component. This is not limited in this application.

**In** some other embodiments, another component in the electronic device 100 other than the camera module 5 may also be located at the opening 36. Another component other than the camera module 5 is disposed in the middle or at the bottom of the electronic device 100. Correspondingly, the opening 36 may alternatively be disposed in the middle or at the bottom. For example, components such as the speaker and the microphone may be disposed at the bottom of the electronic device 100, which conforms to a call habit of the user. Correspondingly, the opening 36 may alternatively be disposed at the bottom, to avoid components such as the speaker and the microphone.

For example, there may be a plurality of openings 36, and the plurality of openings 36 may be disposed at the top, in the middle, and at the bottom of the electronic device 100 in a distributed manner, to avoid a plurality of components.

In some other embodiments, the camera module 5 and another component of the electronic device 100 may alternatively be mounted on a surface of the board body 31.

Refer to FIG. 3 and FIG. 4. FIG. 4 is a diagram of a partial structure of the electronic device 100 shown in FIG. 3 in some other embodiments. FIG. 4 shows structures and a connection relationship of the circuit board 3 and the camera module 5 in some other embodiments. In embodiments shown in FIG. 4, for another structure such as the frame 2 of the electronic device 100, refer to the structure shown in FIG. 3. Details are not described herein again.

For example, as shown in FIG. 3, the opening 36 may extend to an edge of the board body 31. In the embodiments, the opening 36 may extend to the edge of the board body 31. In this case, an opening exists at an edge of a part of the board body 31 on a periphery of the opening 36. Consequently, the part of the board body 31 on the periphery of the opening 36 has lower strength, and is more likely to be affected by stress and deformed. Therefore, it is more necessary to dispose a reinforcement structure.

In some other embodiments, as shown in FIG. 4, the opening 36 may not extend to an edge of the board body 31. In other words, the board body 31 surrounds the opening 36. In the embodiments, the board body 31 on a periphery of the opening 36 is prone to deformation or cracking. A reinforcement structure is disposed on the periphery of the opening 36, so that mechanical strength of a part of the board body 31 on the periphery of the opening 36 can be improved, and reliability of the circuit board 3 can be improved.

For example, a structure such as a reinforcement member and/or an opening may also be disposed in the middle region 34. The reinforcement member in the middle region 34 may be disposed on a periphery of the opening. The reinforcement member in the middle region 34 may be made of a nonmetal material, or may be made of a metal material. This is not limited in this application. The metal material has higher rigidity and toughness, thereby improving mechanical strength and reliability of the board body 31.

For example, another reinforcement structure may be further disposed in the peripheral region 33. The another reinforcement structure and the reinforcement member 32 may be made of a same material or different materials, and may have a same shape or different shapes. The another reinforcement structure may be made of a metal material, or may be made of a nonmetal material.

In embodiments of this application, the reinforcement member 32 disposed in the peripheral region 33 of the board body 31 is made of an existing material, or is obtained by using an existing physical method such as material mixing, embedding, or stacking. In other words, the reinforcement member 32 disposed in the peripheral region 33 of the board body 31 does not include an unknown substance or an unknown substance obtained by using some methods. However, a material of a reinforcement member disposed in the middle region 34 of the board body 31 is not limited in embodiments of this application, and the reinforcement member disposed in the middle region 34 of the board body 31 may be made of an existing material, or may be made of an unknown material. A material of another reinforcement structure disposed in the peripheral region 33 of the board body 31 is also not limited in embodiments of this application, and the another reinforcement structure disposed in the peripheral region 33 of the board body 31 may be made of an existing material, or may be made of an unknown material.

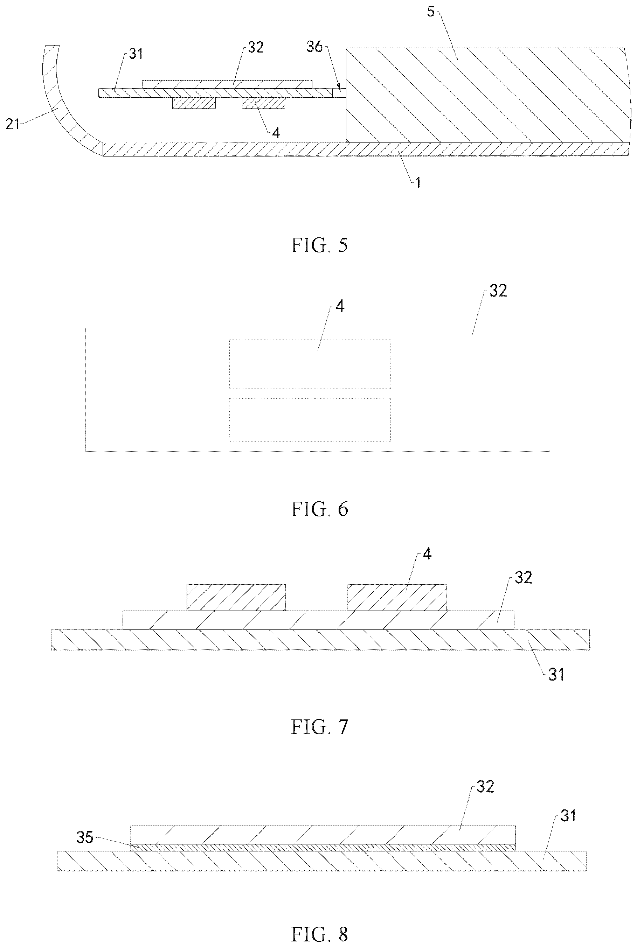

Refer to FIG. 5 and FIG. 6. FIG. 5 is a diagram of an internal partial structure of the electronic device 100 shown in FIG. 3. FIG. 6 is a diagram of projections of the reinforcement member 32 and the radio frequency component 4 shown in FIG. 3 on a plane on which the board body 31 is located.

The radio frequency component 4 of the communication module is electrically connected to the circuit board 3. For example, the radio frequency component 4 may be located in the peripheral region 33 of the board body 31 and is electrically connected to the metal member 21 of the frame 2. The radio frequency component 4 is configured to transmit a radio frequency signal to an antenna, or receive a radio frequency signal from an antenna.

In the embodiments, the radio frequency component 4 is located in the peripheral region 33 of the board body 31, so that the radio frequency component 4 is disposed close to the frame 2, and a transmission distance between the radio frequency component 4 and an antenna located on the frame 2 is short, to reduce a transmission loss and improve antenna performance.

As shown in FIG. 6, the projection of the radio frequency component 4 on the plane on which the board body 31 is located is a first projection, and the projection of the reinforcement member 32 on the plane on which the board body 31 is located is a second projection. For example, at least a part of the first projection may be located in a range of a projection region of the second projection. In embodiments of this application, a projection region of a projection is a continuous surface region formed by connecting outer contours of the projection. The reinforcement member 32 is transmissive for radio frequency signals.

In the embodiments, at least a part of the first projection is located in the range of the projection region of the second projection, so that the radio frequency component 4 is disposed near the reinforcement member 32. The reinforcement member 32 is transmissive for radio frequency signals, and does not affect a radio frequency signal of the radio frequency component 4 disposed near the reinforcement member 32, to ensure electrical performance of the radio frequency component 4, so that an antenna has good radiation performance, and the electronic device 100 has good communication performance.

In addition, at least a part of the first projection may be located in the range of the projection region of the second projection, so that the radio frequency component 4 and the reinforcement member 32 implement reuse in a plane dimension, and a structure in the internal cavity of the entire electronic device 100 is compact, to meet a requirement of a structure design of the electronic device 100.

In some other embodiments, there may alternatively be a gap between the first projection and the second projection. This is not limited in this application.

For example, shapes of a plurality of reinforcement members 32 may be the same, or a shape of at least one reinforcement member 32 may be different from a shape of another reinforcement member 32.

In some embodiments, the reinforcement member 32 may be in a narrow strip shape, and the reinforcement member 32 may extend along a straight line, or may extend along a curve or an irregular line. The reinforcement member 32 may have a uniform or non-uniform width. A width of the reinforcement member 32 is a size of the reinforcement member 32 in a direction perpendicular to an extension direction and parallel to the plane on which the board body 31 is located.

For example, there may be a plurality of reinforcement members 32. Shapes of the plurality of reinforcement members 32 may be the same, or in the plurality of reinforcement members 32, a shape of at least one reinforcement member 32 may be different from a shape of another reinforcement member 32. This is not limited in this application.

Refer to FIG. 5 and FIG. 7. FIG. 7 is a diagram of a partial structure of the electronic device 100 shown in FIG. 3 in still some other embodiments. FIG. 7 shows structures and connection relationships of the radio frequency component 4, the reinforcement member 32, and the board body 31.

For example, as shown in FIG. 5, the radio frequency component 4 and the reinforcement member 32 may be located on two sides of the board body 31 and face away from each other.

**In** some other embodiments, as shown in FIG. 7, the radio frequency component 4 and the reinforcement member 32 may alternatively be located on a same side of the board body 31. The radio frequency component 4 may be located on a side that is of the reinforcement member 32 and that is away from the board body 31. A location of the reinforcement member 32 is flexible, and different locations may be selected according to an internal structure design of the electronic device 100, to meet a space requirement.

**In** the embodiments, a metal through hole may be made on the reinforcement member 32, so that the radio frequency component 4 is electrically connected to the board body 31.

For example, the radio frequency component 4 may be located on any side of the board body 31. For example, as shown in FIG. 5, the radio frequency component 4 may be located on a side that is of the board body 31 and that faces the rear cover 1. **In** some other embodiments, the radio frequency component 4 may alternatively be located on a side that is of the board body 31 and that is away from the rear cover 1.

For example, there may be a plurality of radio frequency components 4, for example, two, three, or five. The plurality of radio frequency components 4 may be located on a same side of the board body 31, or in the plurality of radio frequency components 4, at least one radio frequency component 4 and another radio frequency component 4 are located on two sides of the board body 31 that face away from each other.

For example, the radio frequency component 4 may be electrically connected to the metal member 21 of the frame 2 by using a structure such as a dome.

For example, there may be a plurality of reinforcement members 32, for example, two, four, or five. In the plurality of reinforcement members 32, there may be a first reinforcement member and a second reinforcement member. The first reinforcement member and the second reinforcement member are located on two sides of the board body 31 and face away from each other. In the embodiments, the radio frequency component 4 may be located on a side that is of the first reinforcement member and/or the second reinforcement member and that is away from the board body 31.

For example, the reinforcement member 32 may be made of a nonmetal material. The nonmetal material may be a material such as plastic, rubber, or ceramic. The nonmetal material has small impact on a radio frequency signal passing through the radio frequency component 4, to ensure electrical performance of the radio frequency component 4, so that an antenna has good radiation performance, and the electronic device 100 has good communication performance.

In some embodiments, a dielectric constant of the reinforcement member 32 is less than or equal to 5, and a dielectric loss of the reinforcement member 32 is less than or equal to 0.17, so that the reinforcement member 32 is transmissive for radio frequency signals. For example, the reinforcement member 32 may be made of polyester, epoxy resin, polyimide, or the like.

For example, the reinforcement member 32 may be formed by curing an adhesive applied to a surface of the board body 31, so that the reinforcement member 32 is securely connected to the board body 31. In addition, a form of the adhesive is variable, and the adhesive can be conveniently applied to a location that needs to be reinforced on the board body 31, so that a location of the reinforcement member 32 is flexible, and applicability is high. In addition, a shape of the opening 36 of the board body 31 may be irregular. For example, a groove or a protrusion may be disposed on the board body 31 on a periphery of the opening 36. The adhesive is applicable to various shapes, so that the reinforcement member 32 can fit a shape of the periphery of the opening 36, to achieve good reinforcement effect. In addition, in the embodiments, there is no need to pre-make the reinforcement member 32 and bond the reinforcement member 32 to the board body 31, so that a process is simplified, and costs are reduced.

For example, the adhesive may be cured on the surface of the board body 31 in a manner of thermal curing, moisture curing, UV (ultraviolet, ultraviolet) curing, or the like.

In some embodiments, the reinforcement member 32 may be made of polyester. The polyester is easy to form a film, and connection to the board body 31 is more secure. In some other embodiments, the reinforcement member 32 may alternatively be made of epoxy resin, polyimide, or the like.

In some embodiments, the reinforcement member 32 may include a main body and a plurality of filling members, an elastic modulus of the filling member is greater than an elastic modulus of the main body, the main body is fastened to the board body 31, and the plurality of filling members are distributed on the main body. The filling member can improve mechanical strength of the reinforcement member 32, to improve mechanical strength of the peripheral region of the board body 31.

The reinforcement member 32 is formed by mixing the main body and the plurality of filling members. No chemical reaction occurs between the main body and the plurality of filling members, and the main body and the plurality of filling members maintain original properties. The main body and the plurality of filling members may be separated by using a physical method. **In** addition, a ratio of the main body to the plurality of filling members is not limited in embodiments of this application, and the ratio of the main body to the plurality of filling members may be designed according to a requirement. The elastic modulus of the reinforcement member 32 can be adjusted by designing the ratio of the main body to the plurality of filling members.

For example, the main body may be made of polyester, epoxy resin, polyimide, or the like. The filling member may be made of silicon dioxide, aluminum dioxide, or the like. A shape of the filling member may be a spherical shape, an ellipsoid shape, a polyhedron shape, or another irregular shape. Volumes of the plurality of filling members may be the same, or a volume of at least one filling member may be different from a volume of another filling member. The plurality of filling members may be made of a same material, or a material of at least one filling member may be different from a material of another filling member.

For example, there may be a plurality of reinforcement members 32. The plurality of reinforcement members 32 may be made of a same material, or in the plurality of reinforcement members 32, a material of at least one reinforcement member 32 may be different from a material of another reinforcement member 32. This is not limited in this application.

FIG. 8 is a diagram of a partial structure of the electronic device 100 shown in FIG. 3 in yet some other embodiments. FIG. 8 shows structures and a connection relationship of the reinforcement member 32 and the board body 31.

For example, the circuit board 3 may further include an adhesive member 35 disposed between the board body 31 and the reinforcement member 32. The reinforcement member 32 may be fastened to the board body 31 by using the adhesive member 35. The adhesive member 35 may be pre-made on the board body 31 or the reinforcement member 32, to simplify a process step of fastening the reinforcement member 32 to the board body 31.

For example, the adhesive member 35 may be glue.

**In** some embodiments, the adhesive member 35 may be a glue film formed by glue on a single side surface of the reinforcement member 32. The glue film may be bonded to the surface of the board body 31 in a manner of thermal curing, moisture curing, UV curing, or the like, so that the reinforcement member 32 is fastened to the board body 31.

In some other embodiments, the adhesive member 35 may alternatively be formed by curing glue. Glue may be applied to a single side surface of the reinforcement member 32, and the side to which the glue is applied is bonded to the board body 31, so that the reinforcement member 32 is fastened to the board body 31.

For example, the adhesive member 35 may alternatively be a double-sided tape. Two sides of the double-sided tape are sticky, and are bonded to the reinforcement member 32 and the board body 31 respectively.

In some other embodiments, alternatively, a glue dispenser may be used to perform dispensing on the board body 31, and the reinforcement member 32 is bonded to the board body 31 through dispensing, so that the reinforcement member 32 is fastened to the board body 31.

For example, the adhesive member 35 may be made of a nonmetal material, for example, acrylic resin or modified epoxy resin. The adhesive member 35 is transmissive for radio frequency signals, and does not affect a radio frequency signal passing through the radio frequency component 4, to ensure electrical performance of the radio frequency component 4.

The foregoing descriptions are merely specific implementations of this application, but are not intended to limit the protection scope of this application. Any variation readily figured out by a person skilled in the art within the technical scope of the appended claims shall fall within the protection scope of this application. Embodiments of this application and features in embodiments may be mutually combined provided that no conflict occurs. Therefore, the protection scope of this application is defined by the protection scope of the claims.

## Claims

1. An electronic device (100), comprising:
a frame (2), wherein the frame (2) comprises a metal member (21), and the metal member (21) is used as an antenna;
a circuit board (3), mounted on an inner side of the frame (2), wherein the circuit board (3) comprises a board body (31) and a reinforcement member (32), the board body (31) has a peripheral region (33) close to the frame (2), the reinforcement member (32) is disposed in the peripheral region (33) of the board body (31), ; and
a radio frequency component (4), electrically connected to the circuit board (3), wherein the radio frequency component (4) is located in the peripheral region (33) of the board body (31) and is electrically connected to the metal member (21) of the frame (2), and the radio frequency component (4) is configured to transmit an electrical signal to the antenna or receive an electrical signal from the antenna, wherein
a projection of the radio frequency component (4) on a plane on which the board body (31) is located is a first projection, a projection of the reinforcement member (32) on the plane on which the board body (31) is located is a second projection;
the electronic device (100) **characterised in that**:
the reinforcement member (32) is transmissive for radio frequency signals; and
at least a part of the first projection is located in a range of a projection region of the second projection.

2. The electronic device (100) according to claim 1, wherein the electronic device (100) comprises a camera module (5), the board body (31) is provided with an opening (36), the camera module (5) is located at the opening (36), the reinforcement member (32) is disposed on a periphery of the opening (36), and the radio frequency component (4) is disposed between the camera module (5) and the frame (2).

3. The electronic device (100) according to claim 2, wherein the opening (36) extends to an edge of the board body (31).

4. The electronic device (100) according to any one of claims 1 to 3, wherein the radio frequency component (4) is located on a side that is of the reinforcement member (32) and that is away from the board body (31), or the radio frequency component (4) and the reinforcement member (32) are located on two sides of the board body (31) and face away from each other.

5. The electronic device (100) according to any one of claims 1 to 4, wherein the reinforcement member (32) is made of a nonmetal material.

6. The electronic device (100) according to claim 5, wherein a dielectric constant of the reinforcement member (32) is less than or equal to 5, and a dielectric loss of the reinforcement member (32) is less than or equal to 0.17.

7. The electronic device (100) according to claim 5 or 6, wherein the reinforcement member (32) is formed by curing an adhesive applied to a surface of the board body (31).

8. The electronic device (100) according to claim 7, wherein the reinforcement member (32) is made of polyester, epoxy resin, or polyimide.

9. The electronic device (100) according to claim 7, wherein the reinforcement member (32) comprises a main body and a plurality of filling members, an elastic modulus of the filling member is greater than an elastic modulus of the main body, the main body is fastened to the board body (31), and the plurality of filling members are distributed on the main body.

10. The electronic device (100) according to claim 5 or 6, wherein the circuit board (3) comprises an adhesive member (35) disposed between the board body (31) and the reinforcement member (32), and the reinforcement member (32) is fastened to the board body (31) by using the adhesive member (35).

11. The electronic device (100) according to claim 10, wherein the adhesive member (35) is glue or a double-sided tape.

12. The electronic device (100) according to claim 11, wherein the adhesive member (35) is made of acrylic resin or modified epoxy resin.

## Patentansprüche

1. Elektronische Vorrichtung (100), umfassend:
einen Rahmen (2), wobei der Rahmen (2) ein Metallelement (21) umfasst und das Metallelement (21) als Antenne verwendet wird;
eine Leiterplatte (3), die auf einer Innenseite des Rahmens (2) montiert ist, wobei die Leiterplatte (3) einen Leiterplattenkörper (31) und ein Verstärkungselement (32) umfasst, der Leiterplattenkörper (31) einen Randbereich (33) nahe dem Rahmen (2) aufweist und das Verstärkungselement (32) in dem Randbereich (33) des Leiterplattenkörpers (31) angeordnet ist; und
eine Hochfrequenzkomponente (4), die elektrisch mit der Leiterplatte (3) verbunden ist, wobei sich die Hochfrequenzkomponente (4) in dem Randbereich (33) des Leiterplattenkörpers (31) befindet und elektrisch mit dem Metallelement (21) des Rahmens (2) verbunden ist und die Hochfrequenzkomponente (4) dazu ausgelegt ist, ein elektrisches Signal an die Antenne zu übertragen oder ein elektrisches Signal von der Antenne zu empfangen, wobei
eine Projektion der Hochfrequenzkomponente (4) auf eine Ebene, in der sich der Leiterplattenkörper (31) befindet, eine erste Projektion ist und eine Projektion des Verstärkungselements (32) auf die Ebene, in der sich der Leiterplattenkörper (31) befindet, eine zweite Projektion ist;
die elektronische Vorrichtung (100) **dadurch gekennzeichnet ist, dass**
das Verstärkungselement (32) für Hochfrequenzsignale durchlässig ist; und
zumindest ein Teil der ersten Projektion innerhalb eines Projektionsbereichs der zweiten Projektion liegt.

2. Elektronische Vorrichtung (100) nach Anspruch 1, wobei die elektronische Vorrichtung (100) ein Kameramodul (5) umfasst, der Leiterplattenkörper (31) mit einer Öffnung (36) versehen ist, das Kameramodul (5) an der Öffnung (36) angeordnet ist, das Verstärkungselement (32) am Umfang der Öffnung (36) angeordnet ist und die Hochfrequenzkomponente (4) zwischen dem Kameramodul (5) und dem Rahmen (2) angeordnet ist.

3. Elektronische Vorrichtung (100) nach Anspruch 2, wobei sich die Öffnung (36) bis zu einem Rand des Leiterplattenkörpers (31) erstreckt.

4. Elektronische Vorrichtung (100) nach einem der Ansprüche 1 bis 3, wobei sich die Hochfrequenzkomponente (4) auf einer von dem Leiterplattenkörper (31) abgewandten Seite des Verstärkungselements (32) befindet oder sich die Hochfrequenzkomponente (4) und das Verstärkungselement (32) auf zwei Seiten des Leiterplattenkörpers (31) befinden und voneinander abgewandt sind.

5. Elektronische Vorrichtung (100) nach einem der Ansprüche 1 bis 4, wobei das Verstärkungselement (32) aus einem nichtmetallischen Material hergestellt ist.

6. Elektronische Vorrichtung (100) nach Anspruch 5, wobei eine Dielektrizitätskonstante des Verstärkungselements (32) kleiner als oder gleich 5 ist und ein dielektrischer Verlust des Verstärkungselements (32) kleiner als oder gleich 0,17 ist.

7. Elektronische Vorrichtung (100) nach Anspruch 5 oder 6, wobei das Verstärkungselement (32) durch Aushärten eines Klebstoffs gebildet wird, der auf eine Oberfläche des Leiterplattenkörpers (31) aufgebracht ist.

8. Elektronische Vorrichtung (100) nach Anspruch 7, wobei das Verstärkungselement (32) aus Polyester, Epoxidharz oder Polyimid hergestellt ist.

9. Elektronische Vorrichtung (100) nach Anspruch 7, wobei das Verstärkungselement (32) einen Hauptkörper und eine Mehrzahl von Füllelementen umfasst, der Elastizitätsmodul des Füllelements größer als der Elastizitätsmodul des Hauptkörpers ist, der Hauptkörper an dem Leiterplattenkörper (31) befestigt ist und die Mehrzahl von Füllelementen auf dem Hauptkörper verteilt ist.

10. Elektronische Vorrichtung (100) nach Anspruch 5 oder 6, wobei die Leiterplatte (3) ein Klebeelement (35) umfasst, das zwischen dem Leiterplattenkörper (31) und dem Verstärkungselement (32) angeordnet ist, und das Verstärkungselement (32) unter Verwendung des Klebeelements (35) an dem Leiterplattenkörper (31) befestigt ist.

11. Elektronische Vorrichtung (100) nach Anspruch 10, wobei das Klebeelement (35) Klebstoff oder ein doppelseitiges Klebeband ist.

12. Elektronische Vorrichtung (100) nach Anspruch 11, wobei das Klebeelement (35) aus Acrylharz oder modifiziertem Epoxidharz hergestellt ist.

## Revendications

1. Dispositif électronique (100) comprenant :
un châssis (2), le châssis (2) comprenant un élément métallique (21) et l'élément métallique (21) étant utilisé comme antenne ;
une carte de circuit imprimé (3), montée sur un côté intérieur du châssis (2), la carte de circuit imprimé (3) comprenant un corps de carte (31) et un élément de renfort (32), le corps de carte (31) ayant une région périphérique (33) proche du châssis (2), l'élément de renfort (32) étant disposé dans la région périphérique (33) du corps de carte (31), et
un composant radiofréquence (4), connecté électriquement à la carte de circuit imprimé (3), le composant radiofréquence (4) étant situé dans la région périphérique (33) du corps de carte (31) et étant connecté électriquement à l'élément métallique (21) du châssis (2), et le composant radiofréquence (4) étant configuré pour transmettre un signal électrique à l'antenne ou recevoir un signal électrique de l'antenne, où
une projection du composant radiofréquence (4) sur un plan sur lequel le corps de carte (31) est situé est une première projection, une projection de l'élément de renfort (32) sur le plan sur lequel le corps de carte (31) est situé est une deuxième projection ;
le dispositif électronique (100) étant **caractérisé en ce que** :
l'élément de renfort (32) est transmissif pour les signaux radiofréquence ; et
au moins une partie de la première projection est située dans une plage d'une région de projection de la deuxième projection.

2. Dispositif électronique (100) selon la revendication 1, le dispositif électronique (100) comprenant un module de caméra (5), le corps de carte (31) étant pourvu d'une ouverture (36), le module de caméra (5) étant situé au niveau de l'ouverture (36), l'élément de renfort (32) étant disposé sur une périphérie de l'ouverture (36) et le composant radiofréquence (4) étant disposé entre le module de caméra (5) et le châssis (2).

3. Dispositif électronique (100) selon la revendication 2, dans lequel l'ouverture (36) s'étend jusqu'à un bord du corps de carte (31).

4. Dispositif électronique (100) selon l'une quelconque des revendications 1 à 3, dans lequel le composant radiofréquence (4) est situé sur un côté qui correspond à l'élément de renfort (32) et qui est éloigné du corps de carte (31), ou le composant radiofréquence (4) et l'élément de renfort (32) sont situés sur deux côtés du corps de carte (31) et sont opposés l'un à l'autre.

5. Dispositif électronique (100) selon l'une quelconque des revendications 1 à 4, dans lequel l'élément de renfort (32) est constitué d'un matériau non métallique.

6. Dispositif électronique (100) selon la revendication 5, dans lequel la constante diélectrique de l'élément de renfort (32) est inférieure ou égale à 5, et la perte diélectrique de l'élément de renfort (32) est inférieure ou égale à 0,17.

7. Dispositif électronique (100) selon la revendication 5 ou la revendication 6, dans lequel l'élément de renfort (32) est formé par durcissement d'un adhésif appliqué sur une surface du corps de carte (31).

8. Dispositif électronique (100) selon la revendication 7, dans lequel l'élément de renfort (32) est constitué de polyester, de résine époxy ou de polyimide.

9. Dispositif électronique (100) selon la revendication 7, dans lequel l'élément de renfort (32) comprend un corps principal et une pluralité d'éléments de remplissage, le module d'élasticité de l'élément de remplissage étant supérieur au module d'élasticité du corps principal, le corps principal étant fixé au corps de carte (31), et la pluralité d'éléments de remplissage étant répartis sur le corps principal.

10. Dispositif électronique (100) selon la revendication 5 ou la revendication 6, dans lequel la carte de circuit imprimé (3) comprend un élément adhésif (35) disposé entre le corps de carte (31) et l'élément de renfort (32), et l'élément de renfort (32) est fixé au corps de carte (31) en utilisant l'élément adhésif (35).

11. Dispositif électronique (100) selon la revendication 10, dans lequel l'élément adhésif (35) est une colle ou une bande double face.

12. Dispositif électronique (100) selon la revendication 11, dans lequel l'élément adhésif (35) est constitué de résine acrylique ou de résine époxy modifiée.
